# EUROPEAN PATENT APPLICATION

(11) **EP 4 215 844 A1**
(43) Date of publication of application: **26.07.2023**
(21) Application number: 20954121.8
(22) Date of filing: 17.09.2020
(51) Int. Cl.: F25B 13/00, F25B 1/00

(54) **REFRIGERATION CYCLE DEVICE**

(71) Applicant: MITSUBISHI ELECTRIC CORPORATION, Chiyoda-ku Tokyo 100-8310 (JP)
(72) Inventor: ISHIYAMA, Hiroki, Tokyo 100-8310 (JP)
(74) Representative: Pfenning, Meinig & Partner mbB
(86) International application number: PCT/JP2020/035278
(87) International publication number: WO 2022/059136

(57) **Abstract**

A refrigeration cycle apparatus (11) includes: a refrigerant circuit (20) configured to circulate refrigerant; and a controller (100) configured to control the refrigerant circuit (20). The refrigerant circuit (20) includes a compressor (1), a first heat exchanger (2), a first expansion device (3), a second expansion device (8), a third expansion device (9), a second heat exchanger (4), and a cooler (6) configured to cool a substrate of the controller (100). In a first path of the refrigerant circuit (20), the compressor (1), the first heat exchanger (2), the first expansion device (3), the second expansion device (8), and the second heat exchanger (4) are connected in order of the compressor (1), the first heat exchanger (2), the first expansion device (3), the second expansion device (8), and the second heat exchanger (4). In a second path of the refrigerant circuit (20), the cooler (6) and the third expansion device (9) are connected in order of the cooler (6) and the third expansion device (9) from a first point (5) between the first expansion device (3) and the second expansion device (8) to a second point (7) between the compressor (1) and the second heat exchanger (4).

## Description

### TECHNICAL FIELD

The present disclosure relates to a refrigeration cycle apparatus.

### BACKGROUND ART

It has conventionally been known that, in a refrigeration cycle apparatus including a refrigerant circuit configured to circulate refrigerant, heat is dissipated from a controller that controls the refrigerant circuit.

Japanese Patent Laying-Open No. 2009-257601 (PTL 1) discloses an air conditioner including an electronic device that controls a refrigerant circuit and configured to exchange heat between the electronic device and refrigerant circulating through the refrigerant circuit for cooling the electronic device.

### CITATION LIST

### PATENT LITERATURE

PTL 1: Japanese Patent Laying-Open No. 2009-257601

### SUMMARY OF INVENTION

### TECHNICAL PROBLEM

The air conditioner disclosed in Japanese Patent Laying-Open No. 2009-257601 is configured to cool the electronic device by low-temperature and low-pressure refrigerant having flowed out of an evaporator. Thus, when the refrigerant having flowed out of the evaporator is in a gas-liquid two-phase state in which gas and liquid are mixed, dew condensation is more likely to occur in the electronic device and pipes, with the result that the reliability of the electronic device and thus of the entire apparatus may decrease.

The present disclosure has been made to solve the above-described problems. It is an object of the present disclosure to provide a refrigeration cycle apparatus that performs dissipation of heat from a controller for controlling a refrigerant circuit without, as much as possible, decreasing the reliability of the refrigeration cycle apparatus.

### SOLUTION TO PROBLEM

A refrigeration cycle apparatus according to the present disclosure includes: a refrigerant circuit configured to circulate refrigerant; and a controller configured to control the refrigerant circuit. The refrigerant circuit includes a compressor, a first heat exchanger, a first expansion device, a second expansion device, a third expansion device, a second heat exchanger, and a cooler configured to cool a substrate of the controller. In a first path of the refrigerant circuit, the compressor, the first heat exchanger, the first expansion device, the second expansion device, and the second heat exchanger are connected in order of the compressor, the first heat exchanger, the first expansion device, the second expansion device, and the second heat exchanger. In a second path of the refrigerant circuit, the cooler and the third expansion device are connected in order of the cooler and the third expansion device from a first point between the first expansion device and the second expansion device to a second point between the compressor and the second heat exchanger.

### ADVANTAGEOUS EFFECTS OF INVENTION

According to the present disclosure, in the first path of the refrigerant circuit, the refrigerant decompressed by each of the first expansion device and the second expansion device flows into the second heat exchanger, and in the second path of the refrigerant circuit, the refrigerant decompressed by the first expansion device flows into the cooler configured to cool the substrate of the controller. In this way, the substrate of the controller is cooled not by the refrigerant on the first path decompressed by each of the first expansion device and the second expansion device but by the refrigerant on the second path decompressed by the first expansion device. This makes it possible to prevent, as much as possible, occurrence of dew condensation in the substrate of the controller, so that heat can be dissipated from the controller without, as much as possible, decreasing the reliability of the controller and thus of the entire refrigeration cycle apparatus.

### BRIEF DESCRIPTION OF DRAWINGS

Fig. 1 is a diagram showing a configuration of a refrigeration cycle apparatus according to a first embodiment.
Fig. 2 is a p-h diagram of a refrigeration cycle in the refrigeration cycle apparatus according to the first embodiment.
Fig. 3 is a diagram showing a configuration of a refrigeration cycle apparatus according to a first modification of the first embodiment.
Fig. 4 is a p-h diagram of a refrigeration cycle in the refrigeration cycle apparatus according to the first modification of the first embodiment.
Fig. 5 is a flowchart for illustrating control of a controller in the refrigeration cycle apparatus according to the first modification of the first embodiment.
Fig. 6 is a diagram showing a configuration of a refrigeration cycle apparatus according to a second modification of the first embodiment.
Fig. 7 is a diagram showing a configuration of a refrigeration cycle apparatus according to a third modification of the first embodiment.
Fig. 8 is a flowchart for illustrating control of a controller in the refrigeration cycle apparatus according to the third modification of the first embodiment.
Fig. 9 is a diagram showing a configuration of a refrigeration cycle apparatus according to a fourth modification of the first embodiment.
Fig. 10 is a flowchart for illustrating control of a controller in the refrigeration cycle apparatus according to the fourth modification of the first embodiment.
Fig. 11 is a diagram showing a configuration of a refrigeration cycle apparatus according to a second embodiment.
Fig. 12 is a p-h diagram of a refrigeration cycle in the refrigeration cycle apparatus according to the second embodiment.
Fig. 13 is a diagram showing a configuration of a liquid receiver in a refrigeration cycle apparatus according to a modification of the second embodiment.
Fig. 14 is a p-h diagram of a refrigeration cycle in the refrigeration cycle apparatus according to the modification of the second embodiment.
Fig. 15 is a diagram showing a configuration of a refrigeration cycle apparatus according to a third embodiment.

### DESCRIPTION OF EMBODIMENTS

Hereinafter, embodiments of the present disclosure will be described in detail with reference to the accompanying drawings. While a plurality of embodiments will be hereinafter described, it has been originally intended to combine the configurations described in the respective embodiments as appropriate. In the accompanying drawings, the same or corresponding portions are denoted by the same reference characters, and the description thereof will not be repeated.

### First Embodiment

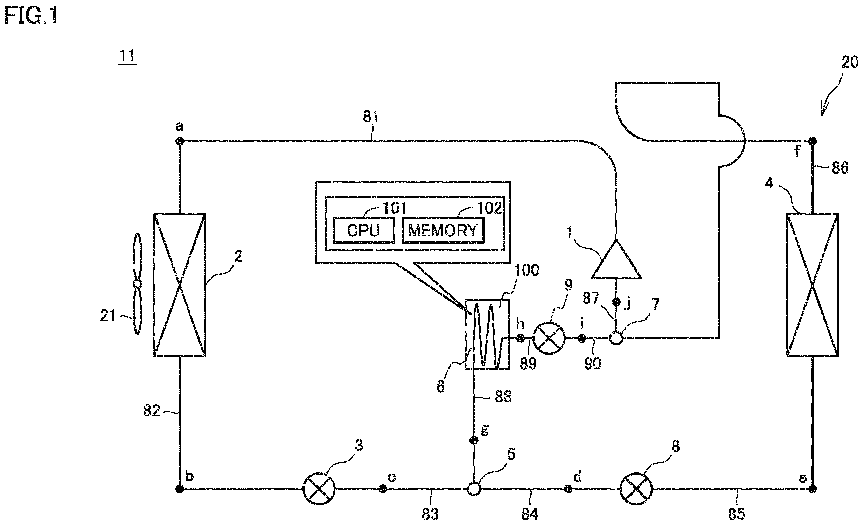

Fig. 1 is a diagram showing a configuration of a refrigeration cycle apparatus 11 according to the first embodiment. Note that Fig. 1 functionally shows the relation of connection between devices and the configuration of arrangement of these devices in refrigeration cycle apparatus 11, but does not necessarily show the arrangement in a physical space.

Referring to Fig. 1, refrigeration cycle apparatus 11 includes a refrigerant circuit 20 and a controller 100. Refrigerant circuit 20 includes a compressor 1, a first heat exchanger 2, a first expansion device 3, a second expansion device 8, a third expansion device 9, a second heat exchanger 4, and a plurality of pipes 81 to 87.

Compressor 1 and first heat exchanger 2 are connected by pipe 81. First heat exchanger 2 and first expansion device 3 are connected by pipe 82. First expansion device 3 and second expansion device 8 are connected by pipes 83 and 84. Second expansion device 8 and second heat exchanger 4 are connected by pipe 85. Second heat exchanger 4 and compressor 1 are connected by pipes 86 and 87.

Compressor 1 is configured to raise the pressure of the low-temperature and low-pressure refrigerant having flowed out of second heat exchanger 4 through pipes 86 and 87. Assuming that the pressure value of the refrigerant on a suction port side of compressor 1 is defined as a first value, and the pressure value of the refrigerant on an outlet port side of compressor 1 is defined as a second value, the second value is larger than the first value. The high-temperature and high-pressure refrigerant obtained by compressor 1 flows out to first heat exchanger 2 through pipe 81.

Compressor 1 is configured, in response to a control signal from controller 100, to be operated and stopped and further to adjust its rotation speed during the operation. Controller 100 adjusts the rotation speed of compressor 1 to thereby adjust the circulation amount of refrigerant, and consequently, can adjust the refrigeration capacity of refrigeration cycle apparatus 11. Compressor 1 may be of various types such as a scroll type, a rotary type, and a screw type, for example.

In refrigeration cycle apparatus 11 according to the first embodiment, first heat exchanger 2 functions as a condenser. First heat exchanger 2 is configured to exchange heat between outdoor air and the high-temperature and high-pressure refrigerant that has flowed out of compressor 1 through pipe 81. Such heat exchange causes condensation of the high-temperature and high-pressure refrigerant. First heat exchanger 2 is provided with a fan 21 for blowing outdoor air so as to enhance the efficiency of heat exchange. Fan 21 supplies to first heat exchanger 2 the outdoor air with which the refrigerant exchanges heat in first heat exchanger 2. The high-temperature and high-pressure refrigerant having passed through first heat exchanger 2 flows out to pipe 82.

First expansion device 3 is configured to lower the pressure of the high-temperature and high-pressure refrigerant having flowed out of first heat exchanger 2 through pipe 82. Assuming that the pressure value of the refrigerant on an outflow port side of first expansion device 3 is defined as a third value, the third value is smaller than the pressure value of the refrigerant on an inflow port side of first expansion device 3 (the second value that is a pressure value of the refrigerant on the outlet port side of compressor 1). Medium-temperature and medium-pressure refrigerant obtained by first expansion device 3 flows out to second expansion device 8 through pipes 83 and 84.

Second expansion device 8 is configured to lower the pressure of the medium-temperature and medium-pressure refrigerant having flowed out of first expansion device 3 through pipes 83 and 84. The pressure value of the refrigerant on the outflow port side of second expansion device 8 (the first value that is a pressure value of the refrigerant on the suction port side of compressor 1) is smaller than the pressure value of the refrigerant on the inflow port side of second expansion device 8 (the third value that is a pressure value of the refrigerant on the outflow port side of first expansion device 3). The low-temperature and low-pressure refrigerant obtained by second expansion device 8 flows out to second heat exchanger 4 through pipe 85.

In refrigeration cycle apparatus 11 according to the first embodiment, second heat exchanger 4 functions as an evaporator. Second heat exchanger 4 is configured to exchange heat between air and the low-temperature and low-pressure refrigerant that has flowed out of second expansion device 8 through pipe 85. Such heat exchange causes evaporation of the low-temperature and low-pressure refrigerant. The low-temperature and low-pressure refrigerant having passed through second heat exchanger 4 flows out to compressor 1 through pipes 86 and 87.

In this way, in refrigerant circuit 20, compressor 1, first heat exchanger 2, first expansion device 3, second expansion device 8, and second heat exchanger 4 are connected in this order via pipes 81 to 87, and these components are connected in an annular shape to form a path through which the refrigerant circulates. Such a path will be hereinafter also referred to as a "first path".

Controller 100 is configured to include a central processing unit (CPU) 101, a memory 102 (a read only memory (ROM) and a random access memory (RAM)) as a storage medium, and an input/output buffer (not shown) through which various signals are input/output. CPU 101 deploys a program, which is stored in the ROM, in the RAM for execution. The program stored in the ROM includes a control program describing the processing procedure for controller 100. Controller 100 controls each of portions in refrigerant circuit 20 in accordance with these control programs. Such control is not necessarily processed by software, but can also be processed by dedicated hardware (processing circuitry).

In refrigeration cycle apparatus 11 having the configuration as described above, controller 100 drives each of actuators for compressor 1 and the like, and during such driving, the temperature of the substrate (not shown) of controller 100 may excessively rise. In controller 100, a prescribed temperature is set in advance, and the temperature of the substrate should be kept below the prescribed temperature in order to ensure the reliability.

In a commonly known technique, a heat sink is installed in a substrate to allow dissipation of heat from the substrate. However, a larger heat sink requires greater force for holding the substrate, with the result that the structure of the refrigeration cycle apparatus becomes complicated. Further, installation of the heat sink may decrease the performance of the refrigeration cycle.

Further, it is also conceivable to cool the substrate of controller 100 by the refrigerant flowing through the first path mainly contributing to the refrigeration cycle. In this case, however, pressure loss may increase on the first path, which may decrease the performance of the refrigeration cycle.

Further, in the case where the substrate of controller 100 is cooled by the low-temperature and low-pressure refrigerant having flowed out of second heat exchanger 4, and when the refrigerant having flowed out of second heat exchanger 4 is in a gas-liquid two-phase state, dew condensation is more likely to occur in the substrate and the pipes, with the result that the reliability of controller 100 and thus of the entire refrigeration cycle apparatus 11 may decrease.

Thus, refrigeration cycle apparatus 11 is configured to provide a bypass path in the first path and guide the medium-temperature and medium-pressure refrigerant to flow through the bypass path so as to cool the substrate of controller 100 by the refrigerant.

Specifically, refrigerant circuit 20 further includes a third expansion device 9, a cooler 6, and a plurality of pipes 88 to 90. Further, refrigerant circuit 20 includes a bypass path connecting: a first point 5 between first expansion device 3 and second expansion device 8; and a second point 7 between compressor 1 and second heat exchanger 4. Such a bypass path will be hereinafter also referred to as a "second path".

In the second path, cooler 6 and third expansion device 9 are connected in this order from first point 5 to second point 7. First point 5 and cooler 6 are connected by pipe 88. Cooler 6 and third expansion device 9 are connected by pipe 89. Third expansion device 9 and second point 7 are connected by pipe 90. In this way, the second path branches from the first path at first point 5 serving as a branch point, and merges with the first path at second point 7 serving as a merging point.

The medium-temperature and medium-pressure refrigerant obtained by first expansion device 3 passes through pipe 83 and thereafter branches at first point 5, and then, a part of the refrigerant flows out to second expansion device 8 through pipe 84 while another part of the refrigerant flows out to cooler 6 through pipe 88.

Cooler 6 is configured to exchange heat between the substrate of controller 100 and the medium-temperature and medium-pressure refrigerant having flowed out through pipe 88. By such heat exchange, cooler 6 cools the substrate of controller 100. Also by such heat exchange, the medium-temperature and medium-pressure refrigerant evaporates. The medium-temperature and medium-pressure refrigerant having passed through cooler 6 flows out to third expansion device 9 through pipe 89.

Third expansion device 9 is configured to lower the pressure of the medium-temperature and medium-pressure refrigerant having flowed out of cooler 6 through pipe 89. The pressure value of the refrigerant on the outflow port side of third expansion device 9 (the first value that is a pressure value of the refrigerant on the suction port side of compressor 1) is smaller than the pressure value of the refrigerant on the inflow port side of third expansion device 9 (the third value that is a pressure value of the refrigerant on the outflow port side of first expansion device 3). The low-temperature and low-pressure refrigerant obtained by third expansion device 9 flows out to compressor 1 through pipes 90 and 87. Thereby, the refrigerant having flowed through the second path that branches from the first path at first point 5 merges with the refrigerant that is to flow through the first path again at second point 7.

As each of first expansion device 3, second expansion device 8, and third expansion device 9 described above, any device can be adoptable as long as it has a configuration for decompressing refrigerant, such as a temperature expansion valve capable of adjusting the flow rate of the refrigerant in accordance with changes in temperature, or a capillary tube capable of adjusting the flow rate of the refrigerant in accordance with a pressure difference. For each of first expansion device 3, second expansion device 8, and third expansion device 9, controller 100 can decrease the pressure difference between the pressure before decompression and the pressure after decompression by controlling the opening (not shown) having the refrigerant passing therethrough in the opening direction, and can increase the pressure difference between the pressure before decompression and the pressure after decompression by controlling the opening in the closing direction.

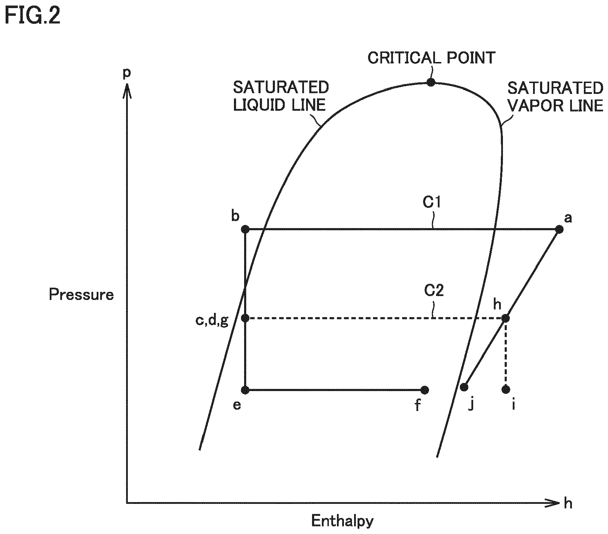

Fig. 2 is a p-h diagram of the refrigeration cycle in refrigeration cycle apparatus 11 according to the first embodiment. In Fig. 2, the vertical axis represents an absolute pressure p while the horizontal axis represents a specific enthalpy h. A reference character C1 represents a refrigeration cycle in the case in which refrigerant flows through the first path in refrigerant circuit 20. A reference character C2 represents a refrigeration cycle in the case in which refrigerant flows through the second path at first point 5 in the first path.

Points "a" to "j" shown in Fig. 2 respectively correspond to points "a" to "j" shown in Fig. 1. Point "a" indicates a position on the outlet port side of compressor 1 and on the inflow port side of first heat exchanger 2. Point "b" indicates a position on the outflow port side of first heat exchanger 2 and on the inflow port side of first expansion device 3. Point "c" indicates a position on the outflow port side of first expansion device 3. Point "d" indicates a position on the inflow port side of second expansion device 8. Point "e" indicates a position on the outflow port side of second expansion device 8 and a position on the inflow port side of second heat exchanger 4. Point "f' indicates a position on the outflow port side of second heat exchanger 4. Point "g" indicates a position on the inflow port side of cooler 6. Point "h" indicates a position on the outflow port side of cooler 6 and a position on the inflow port side of third expansion device 9. Point "i" indicates a position on the outflow port side of third expansion device 9. Point "j" indicates a position on the suction port side of compressor 1.

In refrigeration cycle C1, the change in the graph from point "j" to point "a" represents a change in the refrigerant when the refrigerant flows through compressor 1. The change in the graph from point "a" to point "b" represents a change in the refrigerant when the refrigerant flows through first heat exchanger 2. The change in the graph from point "b" through points "c" and "d" to point "g" represents a change in the refrigerant when the refrigerant flows through first expansion device 3. The change in the graph from point "c", through points "d" and "g" to point "e" represents a change in the refrigerant when the refrigerant flows through second expansion device 8. The change in the graph from point "e" to point "f' represents a change in the refrigerant when the refrigerant flows through second heat exchanger 4.

In refrigeration cycle C2, the change in the graph from point "c" through points "d" and "g" to point "h" represents a change in the refrigerant when the refrigerant flows through cooler 6. The change in the graph from point "h" to point "i" represents a change in the refrigerant when the refrigerant flows through third expansion device 9.

The above-mentioned first value corresponds to the pressure value at each of points "e", "f", "i", and "j". The second value corresponds to the pressure value at each of points "a" and "b". The third value corresponds to the pressure value at each of points "c", "d", "g", and "h".

In refrigeration cycle C1, when the refrigerant is decompressed by first expansion device 3, the pressure value of the refrigerant decreases from the pressure value at point "b" to the pressure value at points "c", "d", and "g". At this time, the refrigerant at points "c", "d", and "g" is in a gas-liquid two-phase state in which gas and liquid are mixed. Then, when the refrigerant is further decompressed by second expansion device 8, the pressure value of the refrigerant decreases from the pressure value at points "c", "d", and "g" to the pressure value at point "e". At this time, the refrigerant at point "e" is in a gas-liquid two-phase state. Then, when the refrigerant decompressed by second expansion device 8 flows through second heat exchanger 4, the refrigerant is brought into the state represented at point "f' by heat exchange. At this time, the refrigerant at point "f' is in a gas-liquid two-phase state. In other words, every refrigerant flows through second heat exchanger 4 while it is in a gas-liquid two-phase state.

In refrigeration cycle C2, when the refrigerant decompressed by first expansion device 3 flows through cooler 6, the refrigerant is brought into the state represented at point "h" by heat exchange. At this time, the refrigerant at point "h" is in a gas state. Then, when the refrigerant is further decompressed by third expansion device 9, the pressure value of the refrigerant decreases from the pressure value at point "h" to the pressure value at point "i". At this time, the refrigerant at point "i" is in a gas state.

When the refrigerant at point "f" and the refrigerant at point "i" merge with each other at second point 7, the refrigerant is brought into a gas state as represented at point "j".

If the second path is not provided and the refrigerant flows through only the first path, the refrigeration cycle transitions from point "e" to point "j". In other words, the refrigerant changes from a gas-liquid two-phase state to a gas state by heat exchange in second heat exchanger 4. Accordingly, inside a part of second heat exchanger 4, the refrigerant completely in a gas state flows therethrough.

As described above, in refrigeration cycle apparatus 11, the second path serving as a bypass path branches from the first path serving as a main path through which the refrigerant mainly flows, and the substrate of controller 100 is cooled by a part of the refrigerant flowing through the second path. This eliminates the need to install a heat sink in the substrate. Further, the substrate of controller 100 is not cooled by the refrigerant flowing through the first path mainly contributing to the refrigeration cycle, which makes it possible to avoid a decrease in performance of the refrigeration cycle due to an increase in pressure loss on the first path.

In refrigeration cycle apparatus 11, the substrate of controller 100 is cooled by the medium-temperature and medium-pressure refrigerant that is greater in pressure value than the low-temperature and low-pressure refrigerant having flowed out of second heat exchanger 4. Specifically, the substrate of controller 100 is cooled not by the refrigerant on the first path decompressed by each of first expansion device 3 and second expansion device 8, but by the refrigerant on the second path decompressed by first expansion device 3. Thereby, occurrence of dew condensation in the substrate of controller 100 and the pipes can be prevented as much as possible, and heat can be dissipated from controller 100 without, as much as possible, decreasing the reliability of controller 100 and thus of the entire refrigeration cycle apparatus 11.

As shown at point "f' in Fig. 2, the refrigerant on the outflow port side of second heat exchanger 4 is in a gas-liquid two-phase state, and the degree of dryness of the refrigerant on the outflow port side of second heat exchanger 4 is suppressed. Therefore, the heat transfer performance in refrigerant circuit 20 can be improved.

### First Modification of First Embodiment

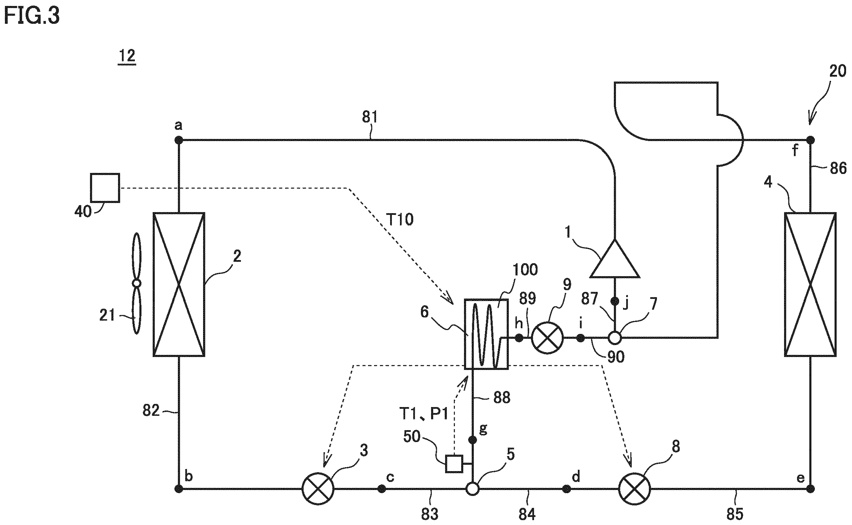

Referring to Figs. 3 to 5, a refrigeration cycle apparatus 12 will be hereinafter described as the first modification of refrigeration cycle apparatus 11 according to the first embodiment. Note that the following describes only differences between refrigeration cycle apparatus 12 and refrigeration cycle apparatus 11 according to the first embodiment.

Fig. 3 is a diagram showing a configuration of refrigeration cycle apparatus 12 according to the first modification of the first embodiment. Referring to Fig. 3, refrigeration cycle apparatus 12 further includes detection sensors 40 and 50.

Detection sensor 40 is provided around refrigerant circuit 20 (for example, around first heat exchanger 2). Detection sensor 40 measures a temperature T 10 of the outdoor air around refrigerant circuit 20, and outputs the measured value to controller 100.

Detection sensor 50 is provided in pipe 88 in the vicinity of first point 5. Detection sensor 50 measures at least one of a temperature T1 and a pressure P1 of the refrigerant flowing through pipe 88, and outputs the measured value to controller 100.

Controller 100 controls at least one of first expansion device 3 and second expansion device 8 such that detection temperature T1 obtained by detection sensor 50 is higher than a dew point temperature T11 and is equal to or lower than outdoor air temperature T10. Dew point temperature T11 may be a fixed value that has been set in advance or may be a value measured by a detection sensor (not shown).

Alternatively, controller 100 controls at least one of first expansion device 3 and second expansion device 8 such that detection pressure P1 obtained by detection sensor 50 is higher than a dew point pressure P11 corresponding to dew point temperature T11 and is equal to or lower than outdoor air pressure P10 corresponding to outdoor air temperature T10.

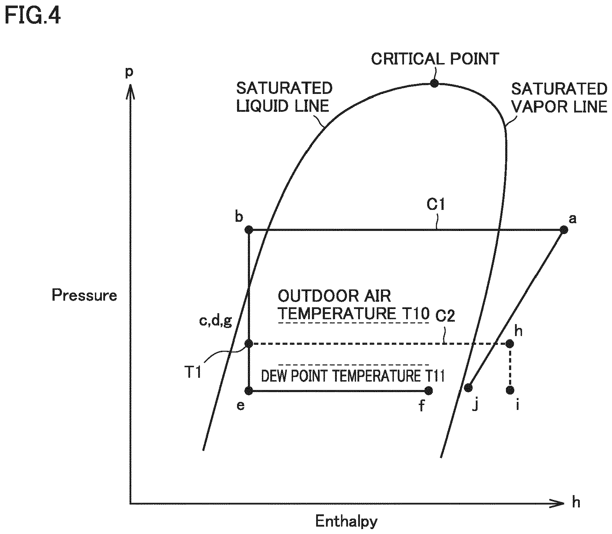

Fig. 4 is a p-h diagram of a refrigeration cycle in refrigeration cycle apparatus 12 according to the first modification of the first embodiment. For example, as shown in Fig. 4, controller 100 adjusts the opening degree of at least one of first expansion device 3 and second expansion device 8 to adjust the pressure value of the refrigerant at points "c", "d", and "g", to thereby set detection temperature T1 to be higher than dew point temperature T11 and to be equal to or lower than outdoor air temperature T10.

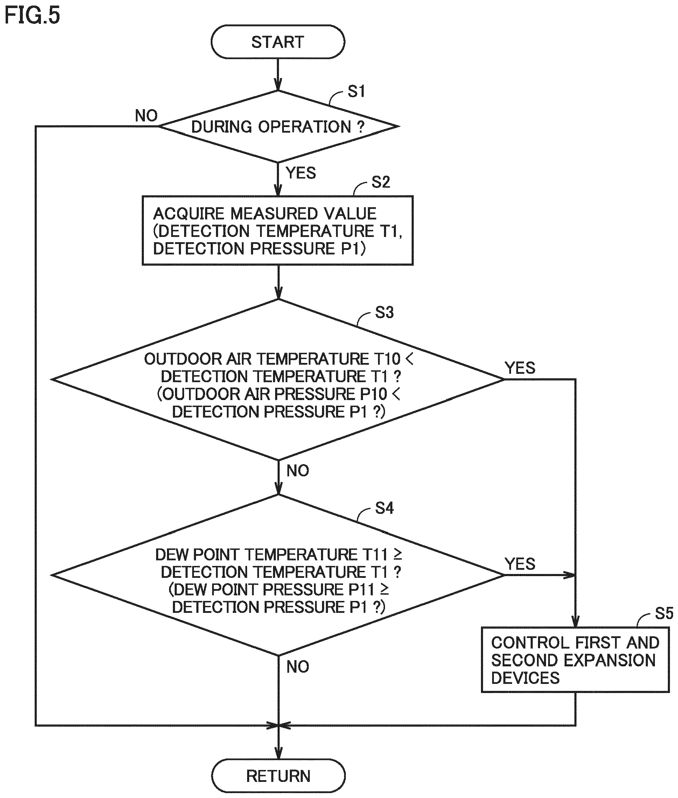

Fig. 5 is a flowchart for illustrating control of controller 100 in refrigeration cycle apparatus 12 according to the first modification of the first embodiment. Controller 100 executes the control program stored in memory 102 to thereby execute the processes in the flowchart shown in Fig. 5. The processes in this flowchart are called from a main control routine of refrigeration cycle apparatus 12 at regular time intervals for execution. In the figure, "S" is used as an abbreviation for "STEP".

Controller 100 determines whether refrigeration cycle apparatus 12 is operating or not (S1). When refrigeration cycle apparatus 12 is not operating (NO in S1), controller 100 returns the control to the main control routine.

When refrigeration cycle apparatus 12 is operating (YES in S1), controller 100 acquires a measured value (detection temperature T1, detection pressure P1) from detection sensor 50 (S2). Controller 100 determines whether or not detection temperature T1 is higher than outdoor air temperature T10 (S3). Alternatively, controller 100 determines whether or not detection pressure P1 is higher than outdoor air pressure P10 (S3).

When detection temperature T1 is higher than outdoor air temperature T10 (YES in S3), or when detection pressure P1 is higher than outdoor air pressure P10 (YES in S3), controller 100 controls at least one of first expansion device 3 and second expansion device 8 (S5). Specifically, controller 100 controls first expansion device 3 in the closing direction and controls second expansion device 8 in the opening direction.

When detection temperature T1 is equal to or lower than outdoor air temperature T10 (NO in S3), controller 100 determines whether or not detection temperature T1 is equal to or lower than dew point temperature T11 (S4). Alternatively, controller 100 determines whether or not detection pressure P1 is equal to or lower than dew point pressure P11 (S4).

When detection temperature T1 is equal to or lower than dew point temperature T11 (YES in S4) or when detection pressure P1 is equal to or lower than dew point pressure P11 (YES in S4), controller 100 controls at least one of first expansion device 3 and second expansion device 8 (S5). Specifically, controller 100 controls first expansion device 3 in the opening direction and controls second expansion device 8 in the closing direction.

When detection temperature T1 is lower than dew point temperature T11 (NO in S4), or when detection pressure P1 is lower than dew point pressure P11 (NO in S4), or after the process in S5, controller 100 returns the control to the main control routine.

As described above, in refrigeration cycle apparatus 12, temperature T1 of the refrigerant flowing into cooler 6 can be set to be higher than dew point temperature T11 and to be equal to or lower than outdoor air temperature T 10, so that occurrence of dew condensation in the substrate of controller 100 and the pipes can be more effectively prevented.

### Second Modification of First Embodiment

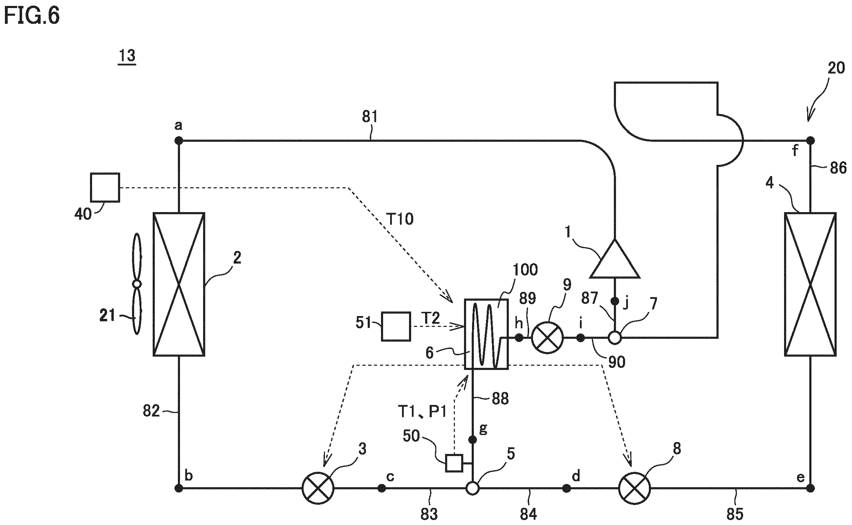

Referring to Fig. 6, a refrigeration cycle apparatus 13 will be hereinafter described as the second modification of refrigeration cycle apparatus 11 according to the first embodiment. Note that the following describes only differences between refrigeration cycle apparatus 13 and refrigeration cycle apparatus 12 according to the first modification of the first embodiment.

Fig. 6 is a diagram showing a configuration of refrigeration cycle apparatus 13 according to the second modification of the first embodiment. Referring to Fig. 6, refrigeration cycle apparatus 13 further includes a detection sensor 51.

Detection sensor 51 measures the dry-bulb temperature, the wet-bulb temperature, or the humidity of the outdoor air, and outputs the measured values to controller 100. Controller 100 calculates dew point temperature T11 based on a measured value T2 obtained by detection sensor 51. Similarly to refrigeration cycle apparatus 12 as described above, controller 100 controls at least one of first expansion device 3 and second expansion device 8 such that detection temperature T1 obtained by detection sensor 50 is higher than dew point temperature T11 and is equal to or lower than outdoor air temperature T10.

As described above, for controlling temperature T1 of the refrigerant flowing into cooler 6, refrigeration cycle apparatus 13 calculates dew point temperature T11 not based on a fixed value as dew point temperature T11 but based on measured value T2 obtained by detection sensor 51, so that occurrence of dew condensation in the substrate of controller 100 and the pipes can be more accurately prevented.

### Third Modification of First Embodiment

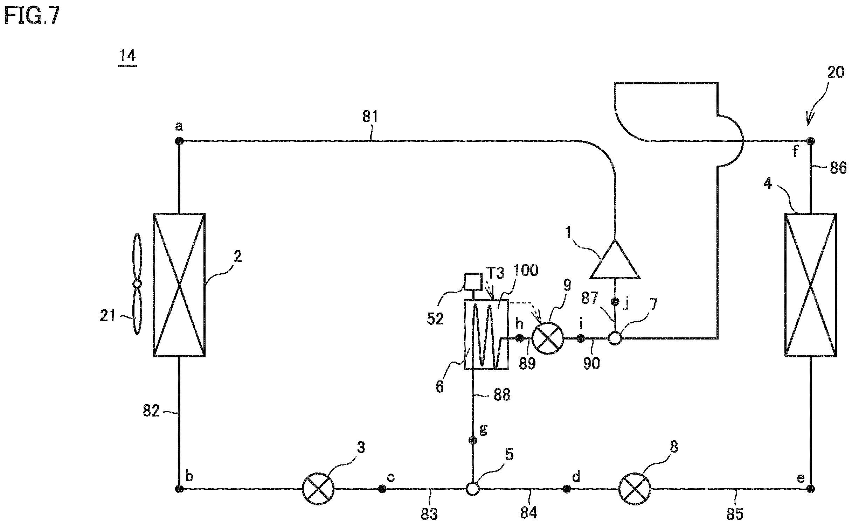

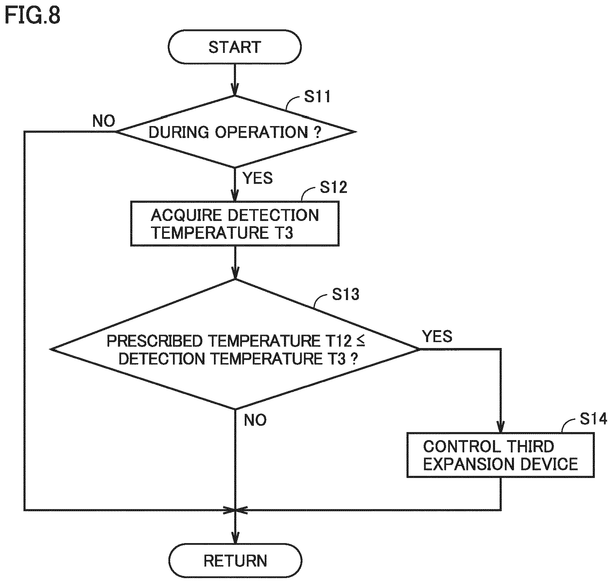

Referring to Figs. 7 and 8, a refrigeration cycle apparatus 14 will be hereinafter described as a third modification of refrigeration cycle apparatus 11 according to the first embodiment. Note that the following describes only differences between refrigeration cycle apparatus 14 and refrigeration cycle apparatus 11 according to the first embodiment.

Fig. 7 is a diagram showing a configuration of a refrigeration cycle apparatus according to the third modification of the first embodiment. Referring to Fig. 7, refrigeration cycle apparatus 14 further includes a detection sensor 52.

Detection sensor 52 measures a temperature T3 of controller 100 and outputs the measured value to controller 100.

Controller 100 controls third expansion device 9 such that detection temperature T3 obtained by detection sensor 52 is lower than a prescribed temperature T12 that has been set in advance. Prescribed temperature T12 is higher than the dew point temperature and ensures the operation of controller 100.

Fig. 8 is a flowchart for illustrating control of controller 100 in refrigeration cycle apparatus 14 according to the third modification of the first embodiment. Controller 100 executes the control program stored in memory 102, to thereby execute the processes in the flowchart shown in Fig. 8. The processes in this flowchart are called from a main control routine of refrigeration cycle apparatus 14 at regular time intervals for execution. In the figure, "S" is used as an abbreviation for "STEP".

Controller 100 determines whether refrigeration cycle apparatus 14 is operating or not (S11). When refrigeration cycle apparatus 14 is not operating (NO in S11), controller 100 returns the control to the main control routine.

When refrigeration cycle apparatus 14 is operating (YES in S11), controller 100 acquires detection temperature T3 from detection sensor 52 (S12). Controller 100 determines whether or not detection temperature T3 is equal to or higher than prescribed temperature T12 (S13).

When detection temperature T3 is equal to or higher than prescribed temperature T12 (YES in S13), controller 100 controls third expansion device 9 (S14). Specifically, controller 100 controls third expansion device 9 in the opening direction.

When detection temperature T3 is lower than prescribed temperature T12 (NO in S13), or after the process in S14, controller 100 returns the control to the main control routine.

As described above, since refrigeration cycle apparatus 14 can set the temperature of controller 100 to be lower than prescribed temperature T12, the reliability of controller 100 can be ensured.

### Fourth Modification of First Embodiment

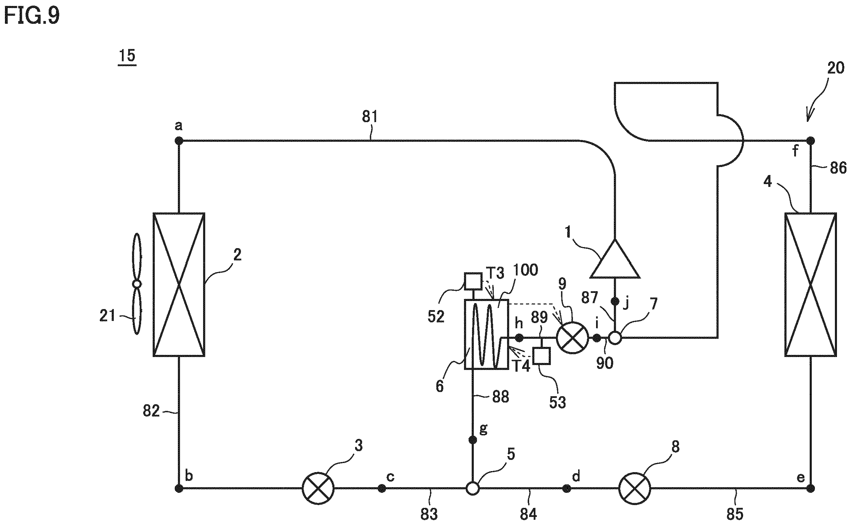

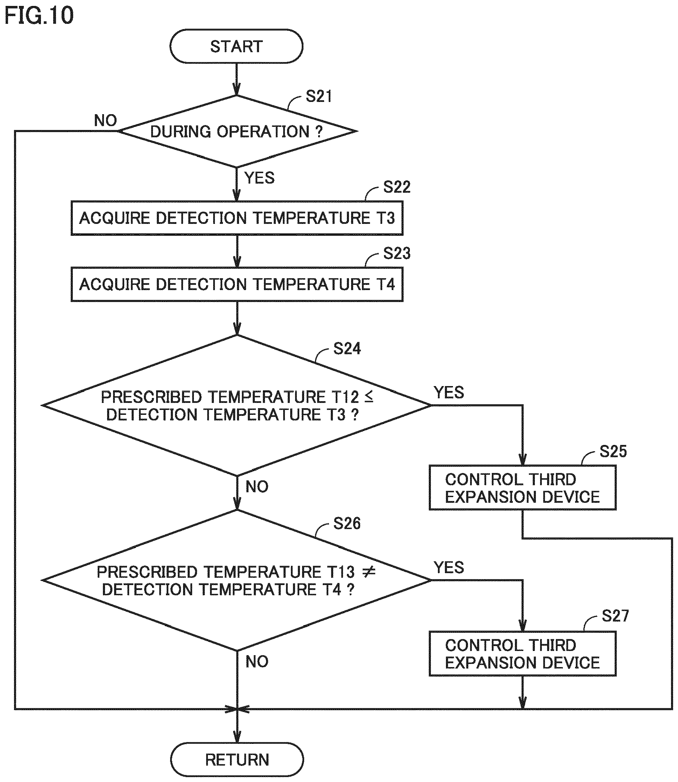

Referring to Figs. 9 and 10, a refrigeration cycle apparatus 15 will be hereinafter described as a fourth modification of refrigeration cycle apparatus 11 according to the first embodiment. Note that the following describes only differences between refrigeration cycle apparatus 15 and refrigeration cycle apparatus 14 according to the third modification of the first embodiment.

Fig. 9 is a diagram showing a configuration of refrigeration cycle apparatus 15 according to the fourth modification of the first embodiment. Referring to Fig. 9, refrigeration cycle apparatus 15 further includes a detection sensor 53.

Detection sensor 53 measures a temperature T4 of the refrigerant flowing through pipe 89 between cooler 6 and third expansion device 9, and outputs the measured value to controller 100.

Controller 100 further controls third expansion device 9 such that detection temperature T4 obtained by detection sensor 53 becomes equal to a prescribed temperature T13 that has been set in advance.

Fig. 10 is a flowchart for illustrating control of controller 100 in refrigeration cycle apparatus 15 according to the fourth modification of the first embodiment. Controller 100 executes the control program stored in memory 102, to thereby execute the processes in the flowchart shown in Fig. 10. The processes in this flowchart are called from a main control routine of refrigeration cycle apparatus 15 at regular time intervals for execution. In the figure, "S" is used as an abbreviation for "STEP".

Controller 100 determines whether refrigeration cycle apparatus 15 is operating or not (S21). When refrigeration cycle apparatus 15 is not operating (NO in S21), controller 100 returns the control to the main control routine.

When refrigeration cycle apparatus 15 is operating (YES in S21), controller 100 acquires detection temperature T3 from detection sensor 52 (S22). Further, controller 100 acquires detection temperature T4 from detection sensor 53 (S23).

Controller 100 determines whether or not detection temperature T3 is equal to or higher than prescribed temperature T12 (S24). When detection temperature T3 is equal to or higher than prescribed temperature T12 (YES in S24), controller 100 controls third expansion device 9 (S25). Specifically, controller 100 controls third expansion device 9 in the opening direction.

When detection temperature T3 is lower than prescribed temperature T12 (NO in S24), controller 100 determines whether or not detection temperature T4 is not equal to prescribed temperature T13 (S26). When detection temperature T4 is not equal to prescribed temperature T13 (YES in S26), controller 100 controls third expansion device 9 (S27). Specifically, when detection temperature T4 is higher than prescribed temperature T13, controller 100 controls third expansion device 9 in the opening direction. On the other hand, when detection temperature T4 is lower than prescribed temperature T13, controller 100 controls third expansion device 9 in the closing direction.

As described above, in refrigeration cycle apparatus 15, temperature T4 of the refrigerant flowing between cooler 6 and third expansion device 9 is set at prescribed temperature T13, and thereby, the temperature of controller 100 can be kept at an appropriate temperature, so that the reliability of controller 100 can be ensured.

### Second Embodiment

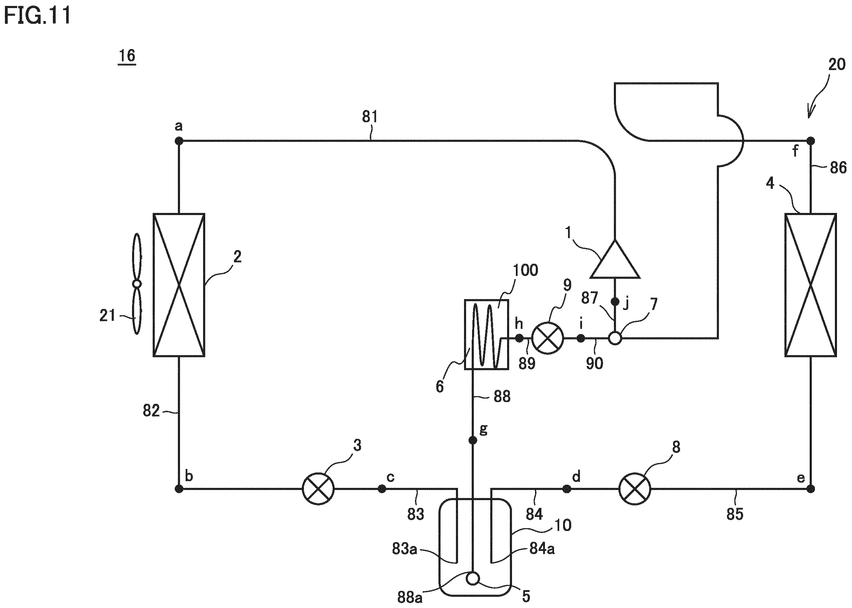

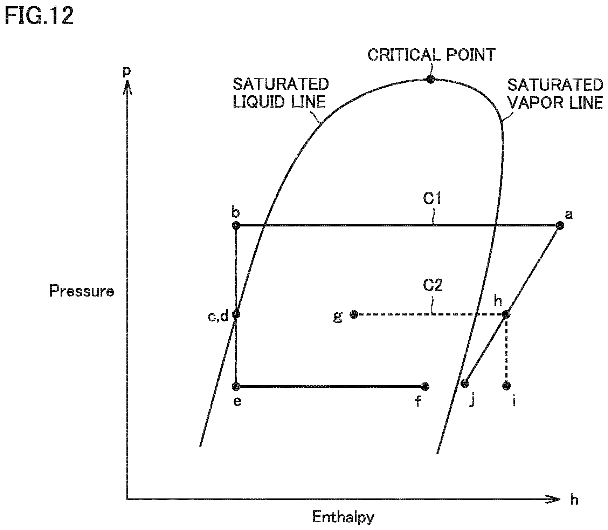

Referring to Figs. 11 and 12, a refrigeration cycle apparatus 16 according to the second embodiment will be hereinafter described. Note that the following describes only differences between refrigeration cycle apparatus 16 and refrigeration cycle apparatus 11 according to the first embodiment.

Fig. 11 is a diagram showing a configuration of refrigeration cycle apparatus 16 according to the second embodiment. Referring to Fig. 11, refrigeration cycle apparatus 16 further includes a liquid receiver 10 (a receiver) at first point 5.

Liquid receiver 10 stores liquid refrigerant having flowed out of first expansion device 3. Inside liquid receiver 10, a first end portion 83a of pipe 83 on the first point 5 side, a second end portion 88a of pipe 88 on the first point 5 side, and a third end portion 84a of pipe 84 on the first point 5 side are connected. Third end portion 84a of pipe 84 is connected at a level equal to or lower than the liquid level of the refrigerant stored in liquid receiver 10, and suctions up the liquid portion of the refrigerant, and then guides the refrigerant to flow out to second expansion device 8 through pipe 84.

Fig. 12 is a p-h diagram of the refrigeration cycle in refrigeration cycle apparatus 16 according to the second embodiment. Referring to Fig. 12, in the refrigeration cycle in refrigeration cycle apparatus 16 according to the second embodiment, the refrigerant at point "d" on the inflow port side of second expansion device 8 is in a saturated liquid state, unlike the refrigeration cycle in refrigeration cycle apparatus 11 according to the first embodiment shown in Fig. 2.

As described above, in refrigeration cycle apparatus 16, the refrigerant on the inflow port side of second expansion device 8 is in a saturated liquid state, so that the refrigerant can be appropriately decompressed in second expansion device 8. Thereby, the controllability of the refrigeration cycle in refrigeration cycle apparatus 16 can be enhanced, so that the reliability of refrigeration cycle apparatus 16 can be improved.

### Modification of Second Embodiment

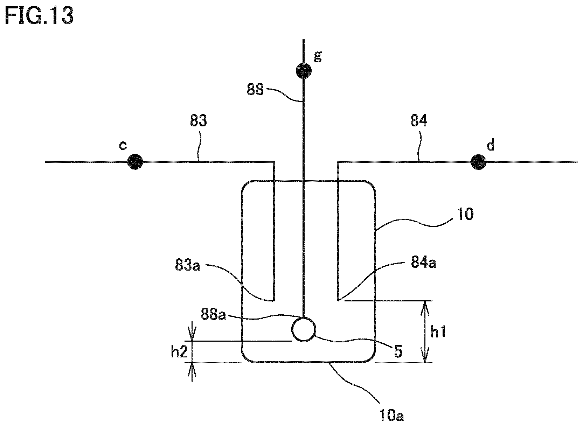

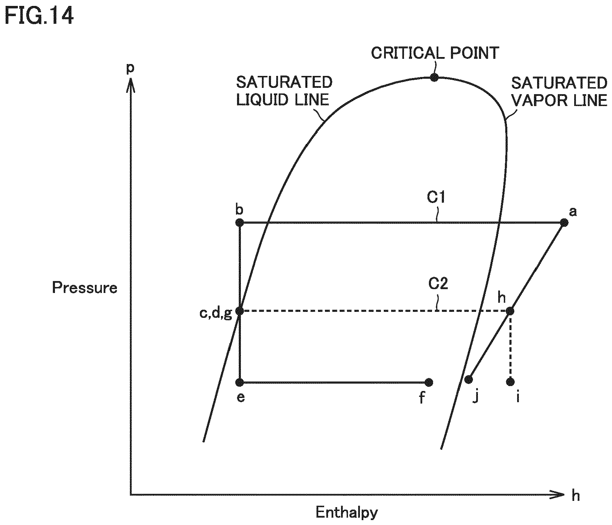

Referring to Figs. 13 and 14, a refrigeration cycle apparatus according to a modification of the second embodiment will be hereinafter described. Note that the following describes only differences between the refrigeration cycle apparatus according to the modification of the second embodiment and refrigeration cycle apparatus 16 according to the second embodiment.

Fig. 13 is a diagram showing a configuration of liquid receiver 10 in the refrigeration cycle apparatus according to the modification of the second embodiment. Referring to Fig. 13, in the refrigeration cycle apparatus according to the modification of the second embodiment, a distance h2 between second end portion 88a of pipe 88 and a bottom portion 10a of liquid receiver 10 is set to be equal to or less than a distance h1 between third end portion 84a of pipe 84 and bottom portion 10a of liquid receiver 10.

Fig. 14 is a p-h diagram of a refrigeration cycle in the refrigeration cycle apparatus according to the modification of the second embodiment. Referring to Fig. 14, in the refrigeration cycle in the refrigeration cycle apparatus according to the modification of the second embodiment, the refrigerant at point "g" on the inflow port side of cooler 6 is in a saturated liquid state, unlike the refrigeration cycle in refrigeration cycle apparatus 16 according to the second embodiment shown in Fig. 12.

As described above, in the refrigeration cycle apparatus according to the modification of the second embodiment, the refrigerant on the inflow port side of cooler 6 is in a saturated liquid state. Thus, in refrigeration cycle C2 shown in Fig. 14, the enthalpy difference between the refrigerant at point "g" on the inflow port side of cooler 6 and the refrigerant at point "h" on the outflow port side of cooler 6 can be set to be larger than that in refrigeration cycle C2 shown in Fig. 12. Thereby, in the refrigeration cycle apparatus according to the modification of the second embodiment, the heat transfer performance in cooler 6 can be enhanced more and the flow rate of the refrigerant for heat exchange can be reduced more than those in the case of refrigeration cycle apparatus 16 according to the second embodiment.

### Third Embodiment

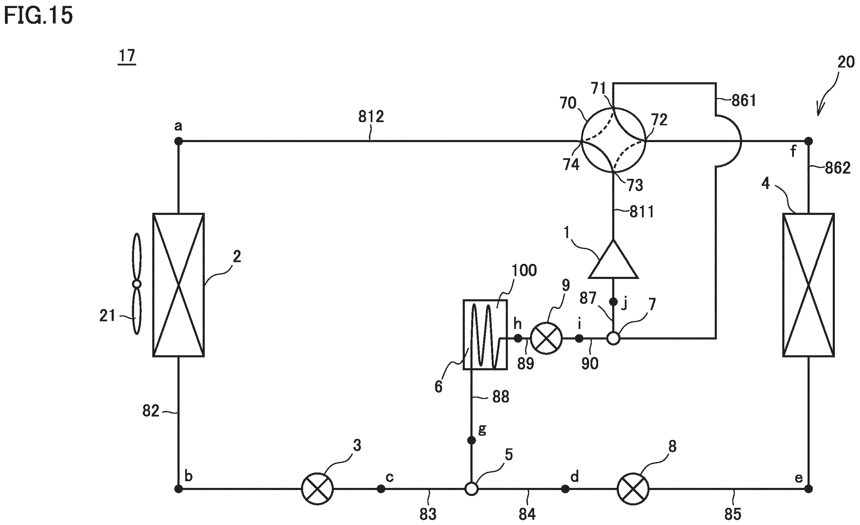

Referring to Fig. 15, a refrigeration cycle apparatus 17 according to the third embodiment will be hereinafter described. Note that the following describes only differences between refrigeration cycle apparatus 17 and refrigeration cycle apparatus 11 according to the first embodiment.

Fig. 15 is a diagram showing a configuration of refrigeration cycle apparatus 17 according to the third embodiment. Referring to Fig. 15, refrigeration cycle apparatus 17 further includes a four-way valve 70.

Four-way valve 70 has a first port 71, a second port 72, a third port 73, and a fourth port 74. Based on the control by controller 100, four-way valve 70 is controlled to be in one of the first state and the second state. In the first state, four-way valve 70 allows communication between first port 71 and second port 72 and allows communication between third port 73 and fourth port 74. In the second state, four-way valve 70 allows communication between first port 71 and fourth port 74 and allows communication between second port 72 and third port 73.

First port 71 is connected to the suction port side of compressor 1 through a pipe 861. Second port 72 is connected to the outflow port side of second heat exchanger 4 through a pipe 862. Third port 73 is connected to the outlet port side of compressor 1 through a pipe 811. Fourth port 74 is connected to the inflow port side of first heat exchanger 2 through a pipe 812.

When refrigeration cycle apparatus 17 performs a cooling operation, first heat exchanger 2 functions as a condenser while second heat exchanger 4 functions as an evaporator. In this case, controller 100 controls four-way valve 70 to be in the first state to thereby guide the refrigerant to flow from second heat exchanger 4 to compressor 1. In other words, during the cooling operation, the refrigerant circulates through compressor 1, first heat exchanger 2, first expansion device 3, second expansion device 8, and second heat exchanger 4 in this order.

When refrigeration cycle apparatus 17 performs a heating operation, first heat exchanger 2 functions as an evaporator while second heat exchanger 4 functions as a condenser. In this case, controller 100 controls four-way valve 70 to be in the second state to thereby guide the refrigerant to flow from compressor 1 to second heat exchanger 4. In other words, during the heating operation, the refrigerant circulates through compressor 1, second heat exchanger 4, second expansion device 8, first expansion device 3, and first heat exchanger 2 in this order.

In this way, in refrigeration cycle apparatus 17, the flow of the refrigerant can be switched between the cooling operation and the heating operation. Even in such a configuration, refrigeration cycle apparatus 17 allows the medium-temperature and medium-pressure refrigerant to flow into cooler 6 through the second path.

Specifically, during the cooling operation, refrigeration cycle apparatus 17 causes first expansion device 3 to decompress the refrigerant having flowed out of first heat exchanger 2 to a medium pressure, guides the decompressed refrigerant to branch at first point 5 as a branch point, and then, guides a part of the refrigerant to flow through second expansion device 8 on the first path and also guides a part of the refrigerant to flow through cooler 6 on the second path. Then, on the second path, refrigeration cycle apparatus 17 causes third expansion device 9 to decompress the refrigerant having flowed into cooler 6 to a low pressure, and guides the decompressed refrigerant to merge with the refrigerant on the first path at second point 7 as a merging point.

On the other hand, during the heating operation, refrigeration cycle apparatus 17 guides the refrigerant having flowed out of first heat exchanger 2 to branch at second point 7 as a branch point, and guides a part of the refrigerant to flow through compressor 1 on the first path and also guides a part of the refrigerant to flow through third expansion device 9 on the second path. Then, on the second path, refrigeration cycle apparatus 17 guides the refrigerant decompressed to a medium pressure by third expansion device 9 to flow through cooler 6, and guides the refrigerant to merge with the refrigerant on the first path at first point 5 as a merging point.

As described above, during each of the cooling operation and the heating operation, refrigeration cycle apparatus 17 guides the refrigerant decompressed to a medium pressure to flow through cooler 6, so that the substrate of controller 100 can be cooled. Thereby, during each of the cooling operation and the heating operation, refrigeration cycle apparatus 17 can dissipate heat from controller 100 without, as much as possible, decreasing the reliability of controller 100 and thus of the entire refrigeration cycle apparatus 17.

### (Summary)

The present disclosure relates to refrigeration cycle apparatuses 11 to 17. Refrigeration cycle apparatus 11 includes a refrigerant circuit 20 configured to circulate refrigerant, and a controller 100 configured to control refrigerant circuit 20. Refrigerant circuit 20 includes a compressor 1, a first heat exchanger 2, a first expansion device 3, a second expansion device 8, a third expansion device 9, a second heat exchanger 4, and a cooler 6 configured to cool a substrate of controller 100. In a first path of refrigerant circuit 20, compressor 1, first heat exchanger 2, first expansion device 3, second expansion device 8, and second heat exchanger 4 are connected in order of compressor 1, first heat exchanger 2, first expansion device 3, second expansion device 8, and second heat exchanger 4. In a second path of refrigerant circuit 20, cooler 6 and third expansion device 9 are connected in order of cooler 6 and third expansion device 9 from a first point 5 between first expansion device 3 and second expansion device 8 to a second point 7 between compressor 1 and second heat exchanger 4.

By providing the configuration as described above, in the first path of refrigerant circuit 20, the refrigerant decompressed by each of first expansion device 3 and second expansion device 8 flows into second heat exchanger 4. Also in the second path of refrigerant circuit 20, the refrigerant decompressed by first expansion device 3 flows into cooler 6 configured to cool the substrate of controller 100. In this way, the substrate of controller 100 is cooled not by the refrigerant on the first path decompressed by each of first expansion device 3 and second expansion device 8 but by the refrigerant on the second path decompressed by first expansion device 3. Thereby, occurrence of dew condensation in the substrate of controller 100 can be prevented as much as possible, and heat can be dissipated from controller 100 without, as much as possible, decreasing the reliability of controller 100 and thus of the entire refrigeration cycle apparatus 11.

Preferably, controller 100 is configured to control at least one of first expansion device 3 and second expansion device 8 such that a temperature T1 of the refrigerant flowing between first point 5 and cooler 6 is higher than a dew point temperature T11 and is equal to or lower than an outdoor air temperature T10.

By providing the configuration as described above, refrigeration cycle apparatus 12 can set temperature T1 of the refrigerant flowing into cooler 6 to be higher than dew point temperature T11 and to be equal to or lower than outdoor air temperature T10, so that occurrence of dew condensation in the substrate of controller 100 and the pipes can be more effectively prevented.

Preferably, controller 100 is configured to control third expansion device 9 such that a temperature T3 of controller 100 is lower than a first prescribed temperature T12.

By providing the configuration as described above, refrigeration cycle apparatus 14 can set the temperature of controller 100 to be lower than prescribed temperature T12, so that the reliability of controller 100 can be ensured.

Preferably, controller 100 is configured to further control third expansion device 9 such that a temperature T4 of the refrigerant flowing between cooler 6 and third expansion device 9 becomes equal to a second prescribed temperature T13.

By providing the configuration as described above, refrigeration cycle apparatus 15 sets a temperature T4 of the refrigerant flowing between cooler 6 and third expansion device 9 to be equal to prescribed temperature T13, and thereby, the temperature of controller 100 can be kept at an appropriate temperature, so that the reliability of controller 100 can be ensured.

Preferably, refrigeration cycle apparatus 16 further includes a liquid receiver 10 provided at first point 5 and configured to store refrigerant. Each of a first end portion 83a, a second end portion 88a, and a third end portion 84a is connected to liquid receiver 10. First end portion 83 is located close to first point 5 in a pipe 83 connecting first expansion device 3 and first point 5, second end portion 88a is located close to first point 5 in a pipe 88 connecting first point 5 and cooler 6, and third end portion 84a is located close to first point 5 in a pipe 84 connecting first point 5 and second expansion device 8.

By providing the configuration as described above, in refrigeration cycle apparatus 16, the refrigerant on the inflow port side of second expansion device 8 is in a saturated liquid state, and thus, the refrigerant can be appropriately decompressed in second expansion device 8. Thereby, the controllability of the refrigeration cycle in refrigeration cycle apparatus 16 can be enhanced, so that the reliability of refrigeration cycle apparatus 16 can be improved.

Preferably, a distance between second end portion 88a and a bottom portion 10a of liquid receiver 10 is equal to or less than a distance between third end portion 84a and bottom portion 10a of liquid receiver 10.

By providing the configuration as described above, in the refrigeration cycle apparatus, the refrigerant on the inflow port side of cooler 6 is in a saturated liquid state, and thus, the enthalpy difference between the refrigerant on the inflow port side of cooler 6 and the refrigerant on the outflow port side of cooler 6 can be set to be relatively large. This allows the refrigeration cycle apparatus to enhance the heat transfer performance in cooler 6 and to reduce the flow rate of the refrigerant for heat exchange.

Preferably, refrigeration cycle apparatus 17 further includes a four-way valve 70 having a first port 71, a second port 72, a third port 73, and a fourth port 74. Four-way valve 70 is controlled to be in one of a first state and a second state. In the first state, four-way valve 70 allows communication between first port 71 and second port 72 and allows communication between third port 73 and fourth port 74. In the second state, four-way valve 70 allows communication between first port 71 and fourth port 74 and allows communication between second port 72 and third port 73. First port 71 is connected to a suction port side of compressor 1. Second port 72 is connected to an outflow port side of second heat exchanger 4. Third port 73 is connected to an outlet port side of the compressor. Fourth port 74 is connected to an inflow port side of first heat exchanger 2.

By providing the configuration as described above, during each of the cooling operation and the heating operation, refrigeration cycle apparatus 17 guides the refrigerant decompressed to a medium pressure to flow through cooler 6, so that the substrate of controller 100 can be cooled. Thereby, during each of the cooling operation and the heating operation, refrigeration cycle apparatus 17 can dissipate heat from controller 100 without, as much as possible, decreasing the reliability of controller 100 and thus of the entire refrigeration cycle apparatus 17.

Although the present embodiments have been described above by exemplifying a cooling/heating machine including a refrigeration cycle apparatus, such a refrigeration cycle apparatus may also be used in an air conditioner or the like.

It should be understood that the embodiments disclosed herein are illustrative and non-restrictive in every respect. The scope of the present disclosure is defined by the terms of the claims, rather than the above description of the embodiments, and is intended to include any modifications within the meaning and scope equivalent to the terms of the claims.

### REFERENCE SIGNS LIST

1 compressor, 2 first heat exchanger, 3 first expansion device, 4 second heat exchanger, 5 first point, 6 cooler, 7 second point, 8 second expansion device, 9 third expansion device, 10 liquid receiver, 10a bottom portion, 11, 12, 13, 14, 15, 16, 17 refrigeration cycle apparatus, 20 refrigerant circuit, 21 fan, 40, 50, 51, 52, 53 detection sensor, 70 four-way valve, 71 first port, 72 second port, 73 third port, 74 fourth port 81, 82, 83, 84, 85, 86, 87, 88, 89, 90, 811, 812, 861, 862 pipe, 83a first end portion, 84a third end portion, 88a second end portion, 100 controller, 102 memory.

## Claims

1. A refrigeration cycle apparatus comprising:
a refrigerant circuit configured to circulate refrigerant; and
a controller configured to control the refrigerant circuit, wherein
the refrigerant circuit comprises a compressor, a first heat exchanger, a first expansion device, a second expansion device, a third expansion device, a second heat exchanger, and a cooler configured to cool a substrate of the controller,
in a first path of the refrigerant circuit, the compressor, the first heat exchanger, the first expansion device, the second expansion device, and the second heat exchanger are connected in order of the compressor, the first heat exchanger, the first expansion device, the second expansion device, and the second heat exchanger, and
in a second path of the refrigerant circuit, the cooler and the third expansion device are connected in order of the cooler and the third expansion device from a first point between the first expansion device and the second expansion device to a second point between the compressor and the second heat exchanger.

2. The refrigeration cycle apparatus according to claim 1, wherein the controller is configured to control at least one of the first expansion device and the second expansion device such that a temperature of the refrigerant flowing between the first point and the cooler is higher than a dew point temperature and is equal to or lower than an outdoor air temperature.

3. The refrigeration cycle apparatus according to claim 1, wherein the controller is configured to control the third expansion device such that a temperature of the controller is lower than a first prescribed temperature.

4. The refrigeration cycle apparatus according to claim 3, wherein the controller is configured to further control the third expansion device such that a temperature of the refrigerant flowing between the cooler and the third expansion device is equal to a second prescribed temperature.

5. The refrigeration cycle apparatus according to claim 1, further comprising a liquid receiver provided at the first point and configured to store the refrigerant, wherein
each of a first end portion, a second end portion, and a third end portion is connected to the liquid receiver, and
the first end portion is located close to the first point in a pipe connecting the first expansion device and the first point, the second end portion is located close to the first point in a pipe connecting the first point and the cooler, and the third end portion is located close to the first point in a pipe connecting the first point and the second expansion device.

6. The refrigeration cycle apparatus according to claim 5, wherein a distance between the second end portion and a bottom portion of the liquid receiver is equal to or less than a distance between the third end portion and the bottom portion of the liquid receiver.

7. The refrigeration cycle apparatus according to claim 1, further comprising a four-way valve having a first port, a second port, a third port, and a fourth port, wherein
the four-way valve is controlled to be in one of a first state and a second state,
in the first state, the four-way valve allows communication between the first port and the second port, and allows communication between the third port and the fourth port, and
in the second state, the four-way valve allows communication between the first port and the fourth port, and allows communication between the second port and the third port,
the first port is connected to a suction port side of the compressor,
the second port is connected to an outflow port side of the second heat exchanger,
the third port is connected to an outlet port side of the compressor, and
the fourth port is connected to an inflow port side of the first heat exchanger.
